# EUROPÄISCHE PATENTSCHRIFT

(11) **EP 2 514 286 B1**
(45) Veröffentlichungstag und Bekanntmachung des Hinweises auf die Patenterteilung: **01.04.2015**
(21) Anmeldenummer: 10798284.5
(22) Anmeldetag: 10.12.2010
(51) Int. Cl.: H05K 5/00, H01R 12/72, H01R 12/73

(54) **STEUERGERÄT FÜR EIN KRAFTFAHRZEUG UND ZUGEHÖRIGES VERFAHREN ZUR MONTAGE EINES STEUERGERÄTS FÜR EIN KRAFTFAHRZEUG**
CONTROL DEVICE FOR A MOTOR VEHICLE AND RELATED METHOD FOR MOUNTING A CONTROL DEVICE FOR A MOTOR VEHICLE
APPAREIL DE COMMANDE POUR VÉHICULE AUTOMOBILE ET PROCÉDÉ ASSOCIÉ PERMETTANT LE MONTAGE D'UN APPAREIL DE COMMANDE POUR VÉHICULE AUTOMOBILE

(30) Priorität: 16.12.2009 DE 102009054770
(43) Veröffentlichungstag der Anmeldung: 24.10.2012
(73) Patentinhaber: Robert Bosch GmbH, 70442 Stuttgart (DE)
(72) Erfinder: GRADTKE, Oliver, 72766 Reutlingen (DE); LUCKNER, Christian, 71229 Leonberg (DE); ROETHLINGSHOEFER, Walter, 72766 Reutlingen (DE)
(86) Internationale Anmeldenummer: PCT/EP2010/069401
(87) Internationale Veröffentlichungsnummer: WO 2011/082947

(56) Entgegenhaltungen:
- DE-A1- 10 162 405
- DE-A1-102005 007 931
- DE-A1-102006 025 977

## Beschreibung

### Stand der Technik

Die Erfindung geht aus von einem Steuergerät für ein Kraftfahrzeug nach der Gattung des unabhängigen Patentanspruchs 1, und von einem korrespondierenden Verfahren zur Montage eines solchen Steuergeräts für ein Kraftfahrzeug nach der Gattung des unabhängigen Patentanspruchs 7.

In der Regel werden keramische Schaltungsträger bzw. Keramiksubstrate in elektronischen Steuergeräten für Kraftfahrzeuge heute durch mit Ultraschall gebondete Drahtverbindungen, die auch als Bonds bezeichnet werden, elektrisch an Stanzgittern kontaktiert. Die Stanzgitter wiederum stellen die elektrischen Verbindungen zu Anschlusspins von Kundensteckern und zu Sonderbauelementen, wie beispielsweise Elektrolytkondensatoren (Elkos), Leistungshalbleitern, Spulen usw. her. Die elektrische Verbindung des Keramiksubstrats zum Stanzgitter mittels Bonds stellt einen sequenziellen Fertigungsprozess dar, welcher sowohl bezüglich der Taktzeit, d.h. die Verarbeitungsdauer bis alle Bonds gesetzt sind, als auch den Investitionen für die Bonds zu erhöhten Wertschöpfungskosten führt.

In der Offenlegungsschrift DE 10 2006 025 977 B4 wird beispielsweise ein Steuergerät mit einem stirnseitig kontaktierten Schaltungsträger beschrieben. Das beschriebene Steuergerät umfasst einen plattenförmigen Schaltungsträger, der in einem Innenraum eines Gehäuses mittels Befestigungsmitteln befestigt ist, und ein Steckerteil, das an einer Wand des Gehäuses ausgebildet ist und Steckerkontaktteile aufweist, die jeweils mit zugeordneten Leiterbahnen auf dem Schaltungsträger elektrisch verbunden sind. Hierbei sind am Schaltungsträger stirnseitig Kontaktflächen ausgebildet und die Steckerkontaktteile sind durch die Wand des Gehäuses geführt und innenseitig jeweils als Kontaktfeder ausgebildet, welche an zugeordneten Kontaktflächen durch Federkraft anliegen.

In der Offenlegungsschrift DE 10 2005 007 931 A1 wird eine Steuergerät mit einem Steckverbinder für ein Kraftfahrzeug offenbart. Das offenbarte Steuergerät umfasst ein Gehäuse und mindestens einen Schaltungsträger, welcher in einem Innenraum des Gehäuses angeordnet ist und mindestens ein erstes Kontaktelement aufweist, welches an mindestens einer Gehäusewand eine elektrische Verbindung mit mindestens einem zweiten Kontaktelement einer Steckeraufnahme herstellt, wobei das zweite Kontaktelement durch die mindestens eine Gehäusewand geführt ist und innenseitig als Kontaktfeder ausgebildet ist, welche an einem zugeordneten ersten Kontaktelement durch Federkraft anliegt, wobei die mindestens eine Gehäusewand Aufnahmemittel für einen ersten Schaltungsträger aufweist, welcher durch im Gehäuse ausgebildete Führungsmittel geführt ist. Hierbei bilden die Führungsmittel und/oder die Aufnahmemittel einen mechanischen Anschlag für den ersten Schaltungsträger aus, welcher so ausgeführt ist, dass die Lage des ersten Schältungsträgers im mechanischen Anschlag mit ausreichend kleiner Toleranz so festlegt ist, dass die elektrische Verbindung zwischen dem mindestens einen ersten Kontaktelement des ersten Schaltungsträgers und dem korrespondierenden als Kontaktfeder ausgeführten zweiten Kontaktelement der Steckeraufnahme hergestellt ist.

### Offenbarung der Erfindung

Das erfindungsgemäße Steuergerät für ein Kraftfahrzeug mit den Merkmalen des unabhängigen Patentanspruchs 1 hat demgegenüber den Vorteil, dass die mindestens eine Gehäusewand, durch die mindestens ein zweites Kontaktelement geführt ist, Aufnahmemittel für einen ersten Schaltungsträger aufweist, wobei der erste Schaltungsträger in einem Innenraum des Gehäuses angeordnet ist, mindestens ein erstes Kontaktelement aufweist und durch Führungsmittel geführt ist, welche beispielsweise an zwei gegenüberliegenden Gehäusewänden angeordnet sind. Hierbei bilden die Führungsmittel und/oder die Aufnahmemittel einen mechanischen Anschlag aus, welcher so ausgeführt ist, dass die Lage des ersten Schaltungsträgers im mechanischen Anschlag mit ausreichend kleiner Toleranz so festlegt ist, dass die elektrische Verbindung zwischen dem mindestens einen ersten Kontaktelement des ersten Schaltungsträgers und dem korrespondierenden als Kontaktfeder ausgeführten zweiten Kontaktelement der Steckeraufnahme hergestellt ist. Das erfindungsgemäße Steuergerät ermöglicht in vorteilhafter Weise, dass der mindestens eine Schaltungsträger durch eine kostengünstige Kontaktiertechnik nach außen mit einem Kabelbaum bzw. einem anderen Steuergerät und intern mit Sonderbauelementen elektrisch verbunden werden kann.

Das erfindungsgemäße Verfahren zur Montage eines solchen Steuergeräts für ein Kraftfahrzeug mit den Merkmalen des unabhängigen Patentanspruchs 7 hat demgegenüber den Vorteil, dass der erste Schaltungsträger geführt in Führungsmitteln, welche beispielsweise an zwei gegenüberliegenden Gehäusewänden angeordnet sind, bis zu einem mechanischen Anschlag in einen ersten Gehäuseteil eingeschoben wird, wobei der mechanische Anschlag für den ersten Schaltungsträger durch in die mindestens eine Gehäusewand eingebrachte Aufnahmemittel und/oder die Führungsmittel ausgebildet wird. Hierbei wird die Lage des ersten Schaltungsträgers im mechanischen Anschlag mit ausreichend kleiner Toleranz so festlegt, dass die elektrische Verbindung zwischen dem mindestens einen ersten Kontaktelement und dem korrespondierenden als Kontaktfeder ausgeführten zweiten Kontaktelement hergestellt wird. Dies ermöglicht in vorteilhafter Weise eine kostensparende Kontaktierung des Schaltungsträgers im Zuge des Fügens der Komponenten, das sich kurze Taktzeiten für die Kontaktierung ergeben.

Erfindungsgemäß sind die Führungsmittel als Führungsnuten ausgeführt, welche jeweils in einer Gehäusewand so eingebracht sind, dass im Bereich vor dem als Kontaktfeder ausgeführten mindestens einen zweiten Kontaktelement eine Verjüngung entsteht. Die Führungsnuten können in vorteilhafter Weise einfach und schnell in die entsprechenden Gehäusewände eingebracht werden. Somit kann der beispielsweise aus Keramiksubstrat gefertigte Schaltungsträger geführt in den Führungsnuten des Gehäuses, das beispielsweise aus Kunststoff gefertigt ist, eingeschoben und im mechanischen Anschlag über in den Gehäusekunststoff eingespritzte Federkontakte zum Kundenstecker kontaktiert werden. Die jeweilige Verjüngung der Führungsnuten im Bereich vor den Federkontakten am mechanischen Anschlag ist so ausgeführt, dass die laterale Lage des Schaltungsträgers mit ausreichend kleiner Toleranz festgelegt ist, um die Federkontakte zu treffen.

Ausführungsformen der vorliegenden Erfindung ermöglichen in vorteilhafter Weise eine Einsparung der Investitionen für Drahtverbindungen bzw. Bonds. Zudem ergibt sich in vorteilhafter Weise eine Baukastenfähigkeit des Systems bezüglich unterschiedlicher Schaltungsträgergrößen, thermischer Anforderungen und unterschiedlicher Kundenstecker.

Durch die in den abhängigen Ansprüchen aufgeführten Maßnahmen und Weiterbildungen sind vorteilhafte Verbesserungen des im unabhängigen Patentanspruch 1 angegebenen Steuergeräts für ein Kraftfahrzeug und des im unabhängigen Patentanspruch 8 angegebenen Verfahrens zur Montage eines Steuergeräts für ein Kraftfahrzeug möglich.

In Ausgestaltung des erfindungsgemäßen Steuergeräts ist ein zweiter Schaltungsträger hinter dem ersten Schaltungsträger in den Führungsmitteln geführt, wobei am zweiten Schaltungsträger mindestens ein als Kontaktfeder ausgeführttes drittes Kontaktelement angeordnet ist, welches zu mindestens einem korrespondierenden vierten Kontaktelement des ersten Schaltungsträgers eine elektrische Verbindung herstellt. Hierbei kann der zweite Schaltungsträger beispielsweise mindestens ein Sonderbauelement, wie beispielsweise einen Elektrolytkondensator (Elko), einen Leistungshalbleiter, eine Spule usw. tragen, welches elektrisch mit der auf dem ersten Schaltungsträger angeordneten elektronischen Schaltung verbunden werden soll. Zudem kann der zweite Schaltungsträger als Teil eines zweiten Gehäuseteils ausgeführt werden, welches mit einem ersten Gehäuseteil gefügt werden soll, in welches der erste Schaltungsträger eingeschoben ist.

In weiterer Ausgestaltung des erfindungsgemäßen Steuergeräts sind das mindestens eine erste Kontaktelement und/oder das mindestens eine vierte Kontaktelement als Kontaktflächen ausgebildet, welche auf der Oberfläche des mindestens einen Schaltungsträgers und/oder am Außenrand des mindestens einen Schaltungsträgers angeordnet sind. Die Ausführung der ersten und/oder vierten Kontaktelemente als Kontaktflächen ermöglicht eine kostensparende Kontaktierung des ersten Schaltungsträgers. Durch Nutzung des Außenrands des ersten Schältungsträgers wird in vorteilhafter Weise die Kontaktierung des ersten Schaltungsträgers ohne Verbrauch von Kontaktierfläche auf dem Schaltungsträger ermöglicht. Die am Außenrand angeordneten als Kontaktflächen ausgeführten ersten und/oder vierten Kontaktelemente können durch metallisch gefüllte Durchkontaktierungen gebildet sein, welche so auf einem Großsubstrat angeordnet sind, dass sie beim Vereinzeln der ersten Schaltungsträger aus dem Großsubstrat teilbar sind. Die am Außenrand angeordneten ersten und/oder vierten Kontaktelemente werden beispielsweise hergestellt, indem in einem Bereich von Ritz- und Brechgräben des Großsubstrats metallisch gefüllte Durchkontaktierungen, so genannte Vias, angeordnet werden. Diese Vias werden durch Leiterbahnen elektrisch mit der elektronischen Schaltung auf dem ersten Schaltungsträger verbunden. Die Vias werden beim Vereinzeln des Großsubstrats in einzelne erste Schaltungsträger per Ritzen und Brechen geteilt. Dabei werden die Vias durchtrennt, ihr Metallkern wird freigelegt und stellt so einen metallischen Kantenkontakt nach außen dar. Da die Vias beispielsweise mit Silber (Ag) gefüllt sind, können die ersten und/oder vierten Kontaktelemente nach dem Vereinzeln mittels einer Leitpaste, eines Leitklebers oder einer Lotschicht geschützt werden.

In weiterer Ausgestaltung des erfindungsgemäßen Steuergeräts ist das als Kontaktfeder ausgeführte mindestens eine zweite Kontaktelement zumindest teilweise in eine Stirnwand des Gehäuses eingespritzt. Durch das Einspritzen der zweiten Kontaktelemente kann in vorteilhafter Weise eine feuchtigkeitsdichte Verbindung zwischen dem Steuergerät und einer Steckeraufnahme hergestellt werden.

In weiterer Ausgestaltung des erfindungsgemäßen Steuergeräts ist ein Kühlkörper vorgesehen, der auf dem ersten Schaltungsträger angeordnet ist. Diese Ausführungsform ist dann sinnvoll, wenn der Kühlkörper ein geringes Gewicht aufweist und das Risiko, dass sich der erste Schaltungsträger durchbiegt und/oder schwingt nahezu auszuschließen ist. Der Kühlkörper wird in üblicher Weise, beispielsweise durch Kleben, auf dem ersten Schaltungsträger befestigt und ist schmaler ausgeführt als der Abstand der Führungsmittel. Die Führung erfolgt bei dieser Ausführungsform allein durch den ersten Schaltungsträger. Alternativ ist der erste Schaltungsträger auf dem Kühlkörper angeordnet, welcher in im Gehäuse ausgebildeten weiteren Führungsmitteln geführt ist. Die alternative Ausführungsform ist dann sinnvoll, wenn der Kühlkörper ein hohes Gewicht aufweist. Bei dieser Ausführungsform kann die Kühlung des ersten Schaltungsträgers bzw. des Keramiksubstrats in vorteilhafter Weise durch Aufkleben des Schaltungsträgers bzw. Keramiksubstrats auf den Kühlkörper umgesetzt werden, wobei der Schaltungsträger schmaler als der Kühlkörper ausgeführt werden kann. Dieser Kühlkörper wird im Gehäuse des Steuergeräts montiert oder als Teil des Gehäuses des Steuergeräts ausgeführt. Zur Führung des Kühlkörpers in den weiteren Führungsmitteln ist der Kühlkörper beispielsweise mit in die Führungsmittel einführbaren Federn versehen. Diese Federn des Kühlkörpers werden dann in oben beschriebener Weise in die Führungsmittel im Gehäuse eingeführt. Der erste Schaltungsträger ist dazu mit geringer Lagetoleranz auf dem Kühlkörper montiert, um die Toleranzen zum Treffen der als Federkontakte ausgeführten zweiten Kontaktelemente nicht zu überschreiten und um eine Verspannung des ersten Schaltungsträgers in seinen Führungsmitteln gegen den Kühlkörper in seinen Führungsmitteln zu vermeiden. Die Fixierung des Kühlkörpers zum Gehäuse geschieht, je nach Anforderung, durch Rasten am Gehäuse oder durch Verkleben.

In Ausgestaltung des erfindungsgemäßen Verfahrens wird ein zweiter Schaltungsträger geführt in den Führungsmitteln hinter dem ersten Schaltungsträger bis zum Anliegen am ersten Schaltungsträger eingeschoben, wobei mindestens ein als Kontaktfeder ausgeführtes am zweiten Schaltungsträger angeordnetes drittes Kontaktelement mit mindestens einem korrespondierenden vierten Kontaktelement des ersten Schaltungsträgers eine elektrische Verbindung herstellt. Zudem kann mit dem Einschieben des zweiten Schaltungsträgers ein zweites Gehäuseteil mit dem ersten Gehäuseteil zusammengefügt werden, wobei die beiden Gehäuseteile an mindestens einer Verbindungsstelle mit einander verbunden werden. Je nach Anforderung können die beiden Gehäuseteile dicht verklebt oder einfach verrastet werden. Im mechanischen Anschlag kontaktieren die beispielsweise in den zweiten Gehäuseteil oder den zweiten Schaltungsträger eingespritzten als Federkontakte ausgeführten dritten Kontaktelemente, welche beispielsweise über Stanzgitter mit dem mindestens einen nicht auf dem ersten Schaltungsträger platzierbaren Sonderbauelement verbunden sind, die elektronische Schaltung des ersten Schaltungsträgers über die als Kontaktflächen ausgeführten vierten Kontaktelemente.

Vorteilhafte Ausführungsformen der Erfindung sind in den Zeichnungen dargestellt und werden nachfolgend beschrieben. In den Zeichnungen bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische perspektivische Darstellung eines ersten Gehäuseteils eines ersten Ausführungsbeispiels eines Gehäuses für ein erfindungsgemäßes Steuergerät.
Fig. 2 zeigt eine schematische Seitenansicht einer Teilschnittdarstellung von Gehäusekomponenten des ersten Ausführungsbeispiels des Gehäuses für ein erfindungsgemäßes Steuergerät.
Fig. 3 zeigt eine schematische Seitenansicht einer Teilschnittdarstellung von Gehäusekomponenten eines zweiten Ausführungsbeispiels eines Gehäuses für ein erfindungsgemäßes Steuergerät.
Fig. 4 zeigt eine schematische Seitenansicht einer Teilschnittdarstellung von Gehäusekomponenten eines dritten Ausführungsbeispiels eines Gehäuses für ein erfindungsgemäßes Steuergerät.
Fig. 5 zeigt eine schematische Draufsicht auf ein Großsubstrat mit mehreren ersten Schaltungsträgern.
Fig. 6 zeigt eine schematische Draufsicht auf zwei noch verbundene erste Schaltungsträger vor einem Trennvorgang.
Fig. 7 zeigt eine schematische Detaildarstellung aus Fig. 6.
Fig. 8 zeigt eine schematische perspektivische Detaildarstellung eines Kontaktelements.

### Ausführungsformen der Erfindung

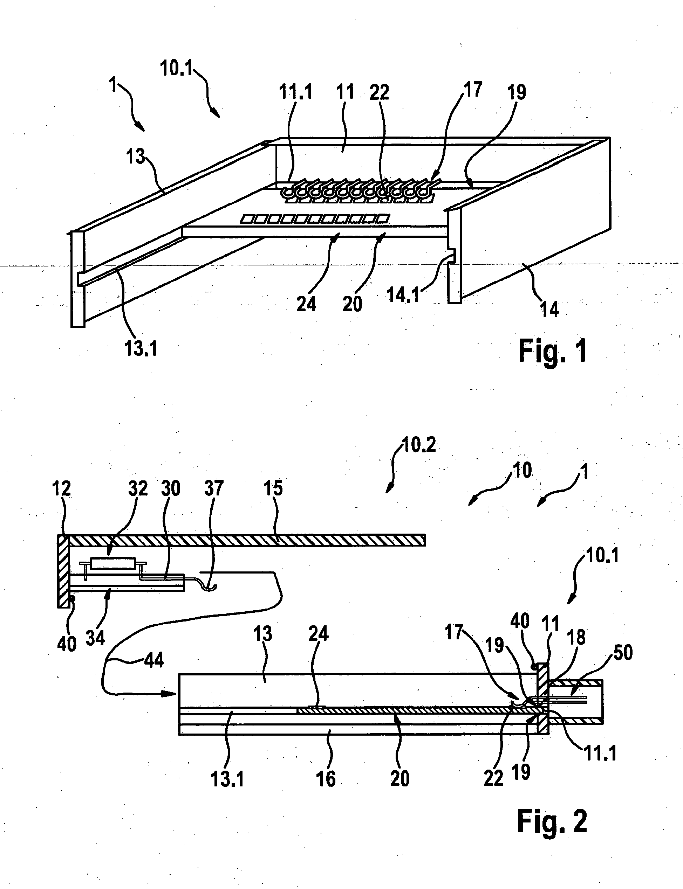

Wie aus Fig. 1 und 2 ersichtlich ist, umfasst ein erstes Ausführungsbeispiel eines Kunststoffgehäuses 10 für ein erfindungsgemäßes Steuergerät 1 für ein Kraftfahrzeug ein erstes Gehäuseteil 10.1, welches zumindest eine vordere Stirnwand 11, zwei Seitenwände 13, 14 und einen ersten Schaltungsträger 20 umfasst, und ein zweites Gehäuseteil 10.2, welches eine hintere Stirnwand 12, einen Gehäusedeckel 15 und einen zweiten Schaltungsträger 30 umfasst. Wie aus Fig. 1 und 2 weiter ersichtlich ist, weist die vordere Stirnwand 11 als Aufnahmenut ausgeführte Aufnahmemittel 11.1 für den ersten Schaltungsträger 20 und die beiden gegenüberliegenden Gehäuseseitenwände 13, 14 weisen jeweils als Führungsnut ausgeführte Führungsmittel 13.1, 14.1 auf, in welchen der erste Schaltungsträger 20 geführt ist. Erfindungsgemäß bilden die Führungsmittel 13.1, 14.1 und/oder Aufnahmemittel 11.1 einen mechanischen Anschlag 19 für den ersten Schaltungsträger 20 aus, welcher so ausgeführt ist, dass die Lage des ersten Schaltungsträgers 20 im mechanischen Anschlag 19 mit ausreichend kleiner Toleranz so festlegt ist, dass eine elektrische Verbindung zwischen mindestens einem ersten Kontaktelement 22 des ersten Schaltungsträgers 20 und mindestens einem korrespondierenden als Kontaktfeder ausgeführten zweiten Kontaktelement 17 einer Steckeraufnahme 50 hergestellt ist. Wie aus Fig. 1 und 2 weiter ersichtlich ist, sind mehrere zweite Kontaktelemente 17 in einem Durchführbereich 18 durch die vordere Stirnwand 11 geführt, welche jeweils mit korrespondierenden als Kontaktflächen ausgebildeten ersten Kontaktelementen 22 eine elektrische Verbindung herstellen, über welche eine auf dem ersten Schaltungsträger 20 angeordnete elektronische Schaltung mit einem außerhalb des Steuergeräts 1 angeordneten Kabelbaum bzw. einem anderen elektrischen Steuergerät elektrisch gekoppelt werden kann. Im dargestellten ersten Ausführungsbeispiel sind die zweiten Kontaktelemente 17 außerhalb des Gehäuses 10 in der Steckeraufnahme 50 als Kontaktpins ausgebildet, im Durchführbereich 18 zumindest teilweise in die Stirnwand 11 eingespritzt und innenseitig als Kontaktfedern ausgebildet, welche an zugeordneten ersten Kontaktelementen 22 durch Federkraft aufliegen.

Die als Führungsnuten ausgeführten Führungsmittel 13.1, 14.1 sind so in die jeweilige Gehäusewand 13, 14 eingebracht, dass im Bereich vor dem als Kontaktfeder ausgeführten mindestens einen zweiten Kontaktelement 17 eine Verjüngung entsteht, welche die laterale Lage des ersten Schaltungsträgers 20 mit ausreichend kleiner Toleranz festlegt, um die als Federkontakte ausgeführten zweiten Kontaktelemente 17 zu treffen.

Gemäß dem erfindungsgemäßen Verfahren zur Montage des Steuergeräts 1 für ein Kraftfahrzeug, wird der erste Schaltungsträger 20 geführt in den Führungsmitteln 13.1, 14.1, welche an zwei gegenüberliegenden Gehäusewänden 13, 14 angeordnet sind, bis zum mechanischen Anschlag 19 in Richtung vordere Stirnwand 11 in den ersten Gehäuseteil 10.1 eingeschoben, wobei der mechanische Anschlag 19 für den ersten Schaltungsträger 20 durch in die mindestens eine Gehäusewand 11 eingebrachte Aufnahmemittel 11.1 und/oder die Führungsmittel 13.1, 14.1 ausgebildet wird. Hierbei wird die Lage des ersten Schaltungsträgers 20 im mechanischen Anschlag 19 mit ausreichend kleiner Toleranz so festlegt, dass die elektrische Verbindung zwischen dem mindestens einen ersten Kontaktelement 22 und dem korrespondierenden als Kontaktfeder ausgeführten zweiten Kontaktelement 17 hergestellt wird. Anschließend kann ein zusätzlicher Gehäuseboden 16 mit dem ersten Gehäuseteil 10.2 beispielsweise durch Kleben oder Verrasten verbunden werden. Alternativ kann der Gehäuseboden 16 bereits vor dem Einschieben des ersten Schaltungsträgers 20 mit dem ersten Gehäuseteil 10.1 verbunden werden und somit quasi Teil des ersten Gehäuseteils 10.1 sein.

Anschließend wird ein zweiter Schaltungsträger 30 geführt in den Führungsmitteln 13.1, 14.1 hinter dem ersten Schaltungsträger 20 bis zum Anliegen am ersten Schaltungsträger 20 entsprechend einer durch einen Pfeil 44 dargestellten Einführrichtung in Richtung vorderer Stirnwand 11 eingeschoben, wobei mindestens ein als Kontaktfeder ausgeführtes am zweiten Schaltungsträger 30 angeordnetes drittes Kontaktelement 37 mit mindestens einem korrespondierenden vierten Kontaktelement 24 des ersten Schaltungsträgers 20 eine elektrische Verbindung herstellt. Im dargestellten ersten Ausführungsbeispiel sind die als Kontaktfedern ausgeführten dritten Kontaktelemente 37 teilweise in den zweiten Schaltungsträger 30 eingespritzt. Zum Einführen in die Führungsmittel 13.1, 14.1 bzw. zur Führung in den Führungsmittels 13.1, 14.1 sind am zweiten Schaltungsträger 30 entsprechende Zungen 34 angeordnet. Der zweite Schaltungsträger 30 trägt beispielsweise mindestens ein Sonderbauelement, wie beispielsweise einen Elektrolytkondensator (Elko), einen Leistungshalbleiter, eine Spule usw., welches über die dritten und vierten Kontaktelemente 37, 24 elektrisch mit der auf dem ersten Schaltungsträger 20 angeordneten elektronischen Schaltung verbunden werden soll. Im dargestellten Ausführungsbeispiel ist der zweite Schaltungsträger 30 als Teil des zweiten Gehäuseteils 10.2 ausgeführt, so dass das zweite Gehäuseteil 10.2 beim Einschieben des zweiten Schaltungsträgers 30 mit dem ersten Gehäuseteil 10.1 gefügt wird. Je nach Anforderung werden die beiden Gehäuseteile 10.1, 10.2 an entsprechenden Verbindungsstellen 40 miteinander dicht verklebt oder einfach verrastet.

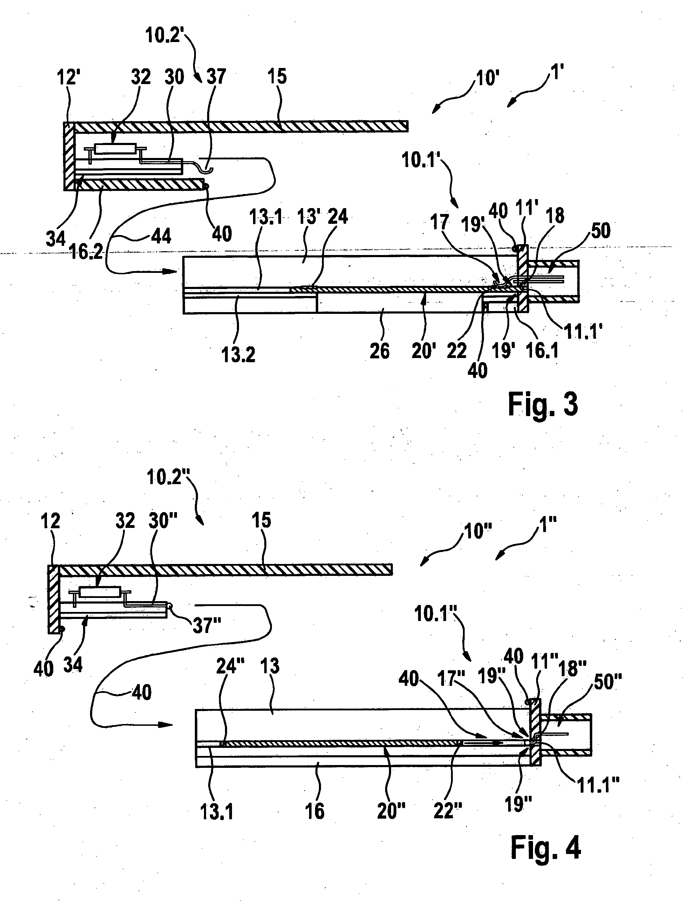

Wie aus Fig. 3 ersichtlich ist, umfasst ein zweites Ausführungsbeispiel eines Kunststoffgehäuses 10' für ein erfindungsgemäßes Steuergerät 1' für ein Kraftfahrzeug analog zum ersten Ausführungsbeispiel ein erstes Gehäuseteil 10.1', welches zumindest eine vordere Stirnwand 11', zwei Seitenwände, von denen nur eine Seitenwand 13 sichtbar ist, und einen ersten Schaltungsträger 20' umfasst, und ein zweites Gehäuseteil 10.2', welches eine hintere Stirnwand 12', einen Gehäusedeckel 15 und einen zweiten Schaltungsträger 30 umfasst. Wie aus Fig. 3 weiter ersichtlich ist, weist die vordere Stirnwand 11' als Aufnahmenut ausgeführte Aufnahmemittel 11.1' für den ersten Schaltungsträger 20' und die beiden gegenüberliegenden Gehäuseseitenwände 13 weisen jeweils als Führungsnut ausgeführte Führungsmittel 13.1 auf, in welchen der erste Schaltungsträger 20' geführt ist. Im Unterschied zum ersten Ausführungsbeispiel ist der erste Schaltungsträger 20' im zweiten Ausführungsbeispiel auf einem Kühlkörper 26 angeordnet, der ebenfalls in als Führungsnuten ausgeführten weiteren Führungsmitteln 13.2 geführt ist. Erfindungsgemäß bilden die Führungsmittel 13.1 und/oder Aufnahmemittel 11.1' einen mechanischen Anschlag 19' für den ersten Schaltungsträger 20' aus, welcher so ausgeführt ist, dass die Lage des ersten Schaltungsträgers 20' im mechanischen Anschlag 19' mit ausreichend kleiner Toleranz so festlegt ist, dass eine elektrische Verbindung zwischen mindestens einem ersten Kontaktelement 22 des ersten Schaltungsträgers 20' und mindestens einem korrespondierenden als Kontaktfeder ausgeführten zweiten Kontaktelement 17 der Steckeraufnahme 50 hergestellt ist. Wie aus Fig. 3 weiter ersichtlich ist, sind analog zum ersten Ausführungsbeispiel mehrere zweite Kontaktelemente 17 in einem Durchführbereich 18 durch die vordere Stirnwand 11' geführt, welche jeweils mit korrespondierenden als Kontaktflächen ausgebildeten ersten Kontaktelementen 22 eine elektrische Verbindung herstellen, über welche eine auf dem ersten Schaltungsträger 20' angeordnete elektronische Schaltung mit einem außerhalb des Steuergeräts 1' angeordneten Kabelbaum bzw. einem anderen elektrischen Steuergerät elektrisch gekoppelt werden kann. Auch im dargestellten zweiten Ausführungsbeispiel sind die zweiten Kontaktelemente 17 außerhalb des Gehäuses 10' in der Steckeraufnahme 50 als Kontaktpins ausgebildet, im Durchführbereich 18 zumindest teilweise in die Stirnwand 11' eingespritzt und innenseitig als Kontaktfedern ausgebildet, welche an zugeordneten ersten Kontaktelementen 22' durch Federkraft aufliegen.

Durch die Anordnung des ersten Schaltungsträgers 20' auf dem Kühlkörper 26 kann die Kühlung des ersten Schaltungsträgers 20' bzw. des Keramiksubstrats in vorteilhafter Weise umgesetzt werden. Im dargestellten zweiten Ausführungsbeispiel ist der Kühlkörper 26 als Teil des Bodens des Gehäuses 10' des Steuergeräts 1' ausgeführt. Zur Führung des Kühlkörpers 26 in den weiteren Führungsmitteln 13.2 ist der Kühlkörper 26 beispielsweise mit in die weiteren Führungsmittel 13.2 einführbaren nicht dargestellten Federn versehen. Diese Federn des Kühlkörpers 26 werden dann in oben beschriebener Weise in die weiteren Führungsmittel 13.2 im Gehäuse 10' eingeführt. Der erste Schaltungsträger 20' ist dazu mit geringer Lagetoleranz auf dem Kühlkörper 26 montiert, um die Toleranzen zum Treffen der als Federkontakte ausgeführten zweiten Kontaktelemente 17 nicht zu überschreiten und um eine Verspannung des ersten Schaltungsträgers 20' in seinen Führungsmitteln 13.1 gegen den Kühlkörper 26 in seinen Führungsmitteln 13.2 zu vermeiden. Im dargestellten zweiten Ausführungsbeispiel ist ein erstes Bodenteil 16.1 mit dem ersten Gehäuseteil 10.1' verbunden. Alternativ kann der erste Schaltungsträger 20' schmaler als der Kühlkörper 26 ausgeführt werden, so dass die Führung nur durch den Kühlkörper 26 in den weiteren Führungsmitteln 13.2 erfolgt. Bei einer solchen Ausführungsform übernehmen die weiteren Führungsmittel 13.2 die Funktionen der Führungsmittel 13.1, so dass auf die Führungsmittel 13.1 verzichtet werden kann.

Gemäß dem erfindungsgemäßen Verfahren zur Montage des Steuergeräts 1' für ein Kraftfahrzeug, wird der Kühlkörper 26 mit dem ersten Schaltungsträger 20' geführt in den Führungsmitteln 13.1, 13.2, welche an zwei gegenüberliegenden Gehäusewänden angeordnet sind, von denen nur eine Gehäusewand 13' sichtbar ist, in Richtung vordere Stirnwand 11' bis zum mechanischen Anschlag 19' in den ersten Gehäuseteil 10.1' eingeschoben, wobei der mechanische Anschlag 19' für den ersten Schaltungsträger 20' durch in die mindestens eine Gehäusewand 11' eingebrachte Aufnahmemittel 11.1' und/oder die Führungsmittel 13.1 ausgebildet wird. Hierbei wird die Lage des ersten Schaltungsträgers 20' im mechanischen Anschlag 19' mit ausreichend kleiner Toleranz so festlegt, dass die elektrische Verbindung zwischen dem mindestens einen ersten Kontaktelement 22' und dem korrespondierenden als Kontaktfeder ausgeführten zweiten Kontaktelement 17 hergestellt wird. Gleichzeitig kommt der Kühlkörper 26 am ersten Bodenteil 16.1 zur Anlage und wird an einer Verbindungsstelle 40 mit diesem beispielsweise durch Kleben oder Verrasten verbunden, so dass der Kühlkörper 26 einen Teil des Gehäusebodens bildet.

Anschließend wird ein zweiter Schaltungsträger 30' geführt in den Führungsmitteln 13.1 hinter dem ersten Schaltungsträger 20' bis zum Anliegen am ersten Schaltungsträger 20' entsprechend einer durch einen Pfeil 44 dargestellten Einführrichtung in Richtung vordere Stirnseite 11' eingeschoben, wobei analog zum ersten Ausführungsbeispiel mindestens ein als Kontaktfeder ausgeführtes am zweiten Schaltungsträger 30 angeordnetes drittes Kontaktelement 37 mit mindestens einem korrespondierenden vierten Kontaktelement 24 des ersten Schaltungsträgers 20 eine elektrische Verbindung herstellt. Auch im dargestellten zweiten Ausführungsbeispiel sind die als Kontaktfedern ausgeführten dritten Kontaktelemente 37 teilweise in den zweiten Schaltungsträger 30 eingespritzt. Zum Einführen in die Führungsmittel 13.1 bzw. zur Führung in den Führungsmitteln 13.1 sind am zweiten Schaltungsträger 30 entsprechende Zungen 34 angeordnet. Der zweite Schaltungsträger 30 trägt beispielsweise mindestens ein Sonderbauelement, welches über die dritten und vierten Kontaktelemente 37, 24 elektrisch mit der auf dem ersten Schaltungsträger 20' angeordneten elektronischen Schaltung verbunden werden soll. Auch im dargestellten zweiten Ausführungsbeispiel ist der zweite Schaltungsträger 30 als Teil des zweiten Gehäuseteils 10.2' ausgeführt, das zusätzlich einen zweiten Bodenteil 16.2 aufweist, so dass das zweite Gehäuseteil 10.2' beim Einschieben des zweiten Schaltungsträgers 30 mit dem ersten Gehäuseteil 10.1' und dem Kühlkörper 26 gefügt wird. Je nach Anforderung werden die beiden Gehäuseteile 10.1', 10.2' an entsprechenden Verbindungsstellen 40 miteinander dicht verklebt oder einfach verrastet.

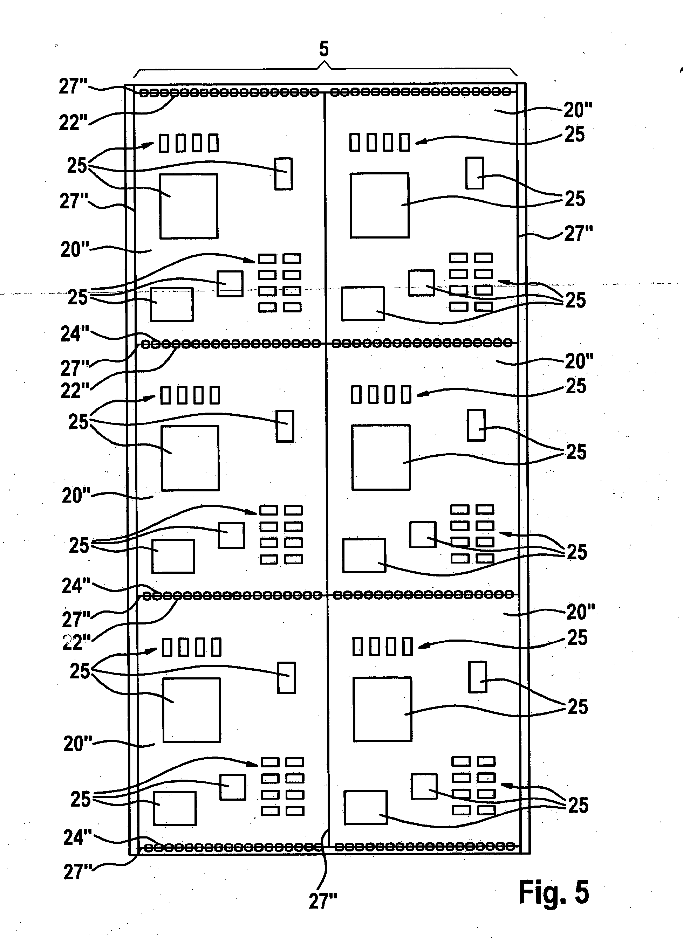

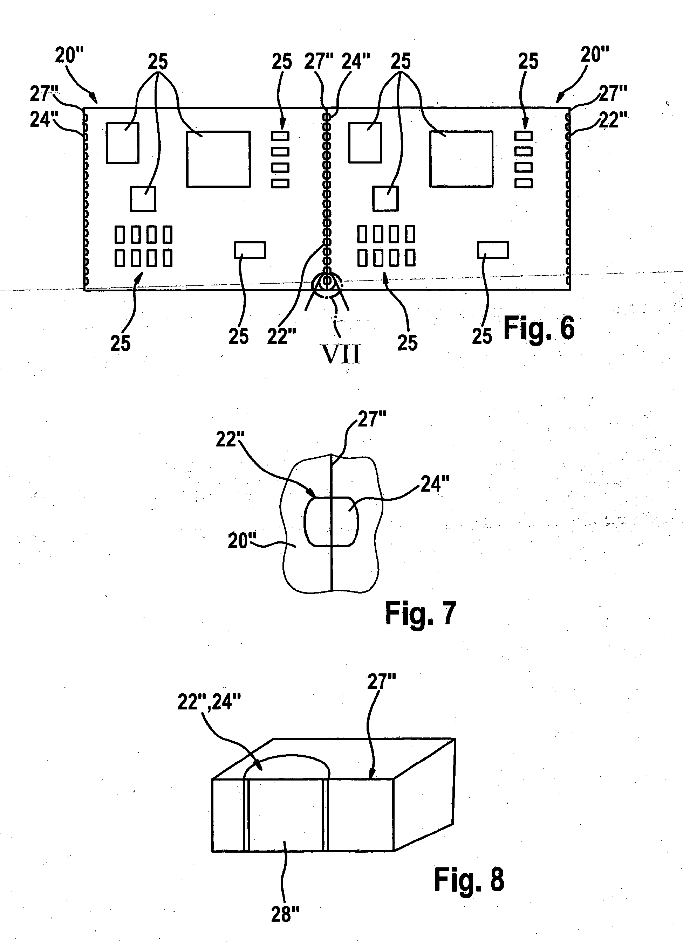

Wie aus Fig. 4 ersichtlich ist, umfasst ein drittes Ausführungsbeispiel eines Kunststoffgehäuses 10" für ein erfindungsgemäßes Steuergerät 1" für ein Kraftfahrzeug analog zum ersten Ausführungsbeispiel ein erstes Gehäuseteil 10.1", welches zumindest eine vordere Stirnwand 11", zwei Seitenwände, von denen nur eine Seitenwand 13 sichtbar ist, und einen ersten Schaltungsträger 20" umfasst, und ein zweites Gehäuseteil 10.2", welches eine hintere Stirnwand 12, einen Gehäusedeckel 15 und einen zweiten Schaltungsträger 30" umfasst. Wie aus Fig. 4 weiter ersichtlich ist, entspricht das dritte Ausführungsbeispiel außer bei den Kontaktierungen im Wesentlichen dem ersten Ausführurigsbeispiel, so dass auf eine wiederholende Beschreibung von bereits bekannte Komponenten verzichtet wird. Im Unterschied zum ersten Ausführungsbeispiel sind die als Kontaktflächen ausgebildeten ersten und/oder vierten Kontaktelemente 22", 24" am Außenrand des ersten Schaltungsträgers 20" angeordnet. Diese Ausführung der ersten und/oder vierten Kontaktelemente wird nachfolgend unter Bezugnahme auf Fig. 5 bis 8 im Detail beschrieben. Durch die Anordnung am Außenrand des ersten Schaltungsträgers 20" werden auch die Ausführungen als Federelemente der zweiten und dritten Kontaktelemente 17" und 37" entsprechend verkürzt und angepasst. So sind die als Federelemente ausgeführten zweiten Kontaktelemente 17" beispielsweise in den als Aufnahmenut ausgeführten Aufnahmemitteln 11.1" angeordnet, so dass der umspritzte Teil der zweiten Kontaktelemente 17" und der Durchführbereich 18" entsprechend kleiner ausfallen. Zudem kann sich auch die Anordnung der Kontaktpins in der Steckeraufnahme 50" verändern.

Gemäß dem erfindungsgemäßen Verfahren zur Montage des Steuergeräts 1" für ein Kraftfahrzeug, wird der erste Schaltungsträger 20" geführt in den Führungsmitteln 13.1, welche an zwei gegenüberliegenden Gehäusewänden angeordnet sind, von denen nur eine Gehäüsewand 13 sichtbar ist, in Richtung vordere Stirnwand 11" bis zum mechanischen Anschlag 19" in den ersten Gehäuseteil 10.1" eingeschoben, wobei der mechanische Anschlag 19" für den ersten Schaltungsträger 20" durch in die mindestens eine Gehäusewand 11" eingebrachte Aufnahmemittel 11.1" und/oder die Führungsmittel 13.1 ausgebildet wird. Hierbei wird die Lage des ersten Schaltungsträgers 20" im mechanischen Anschlag 19" mit ausreichend kleiner Toleranz so festlegt, dass die elektrische Verbindung zwischen dem mindestens einen ersten Kontaktelement 22" und dem korrespondierenden als Kontaktfeder ausgeführten zweiten Kontaktelement 17" hergestellt wird. Anschließend kann ein zusätzlicher Gehäuseboden 16 mit dem ersten Gehäuseteil 10.2" beispielsweise durch Kleben oder Verrasten verbunden werden. Alternativ kann der Gehäuseboden 16 bereits vor dem Einschieben des ersten Schaltungsträgers 20" mit dem ersten Gehäuseteil 10.1" verbunden werden und somit quasi Teil des ersten Gehäuseteils 10.1" sein.

Anschließend wird ein zweiter Schaltungsträger 30" geführt in den Führungsmitteln 13.1 hinter dem ersten Schaltungsträger 20" bis zum Anliegen am ersten Schaltungsträger 20" entsprechend einer durch einen Pfeil 44 dargestellten Einführrichtung in Richtung vordere Stirnwand 11" eingeschoben, wobei mindestens ein als Kontaktfeder ausgeführtes am zweiten Schaltungsträger 30" angeordnetes drittes Kontaktelement 37" mit mindestens einem korrespondierenden vierten Kontaktelement 24" des ersten Schaltungsträgers 20" eine elektrische Verbindung herstellt. Auch im dargestellten dritten Ausführungsbeispiel sind die als Kontaktfedern ausgeführten dritten Kontaktelemente 37" teilweise in den zweiten Schaltungsträger 30" eingespritzt. Zum Einführen in die Führungsmittel 13.1 bzw. zur Führung in den Führungsmittels 13.1 sind am zweiten Schaltungsträger 30" entsprechende Zungen 34 angeordnet. Der zweite Schaltungsträger 30" trägt beispielsweise mindestens ein Sonderbauelement, welches über die dritten und vierten Kontaktelemente 37", 24" elektrisch mit der auf dem ersten Schaltungsträger 20" angeordneten elektronischen Schaltung verbunden werden soll. Auch im dargestellten dritten Ausführungsbeispiel ist der zweite Schaltungsträger 30" als Teil des zweiten Gehäuseteils 10.2" ausgeführt, so dass das zweite Gehäuseteil 10.2" beim Einschieben des zweiten Schaltungsträgers 30" mit dem ersten Gehäuseteil 10.1" gefügt wird. Je nach Anforderung werden die beiden Gehäuseteile 10.1 ", 10.2" an entsprechenden Verbindungsstellen 40 miteinander dicht verklebt oder einfach verrastet.

Wie aus Fig. 5 bis 8 ersichtlich ist, sind die am Außenrand des jeweiligen ersten Schaltungsträgers 20" angeordneten als Kontaktflächen ausgeführten ersten und/oder vierten Kontaktelemente 22", 24" durch metallisch gefüllte Durchkontaktierungen gebildet, welche so auf einem Großsubstrat 5 angeordnet sind, dass sie beim Vereinzeln der ersten Schaltungsträger 20" aus dem Großsubstrat 5 geteilt werden. Wie aus Fig. 5 ersichtlich ist, umfasst das Großsubstrat 5 im dargestellten Ausführungsbeispiel sechs erste Schaltungsträger 10", die mit entsprechenden elektronischen Bauelementen 25 bestückt sind, die beispielsweise eine elektronische Schaltung bilden. Die einzelnen ersten Schaltungsträger 20" sind durch mehrere senkrechte bzw. waagerechte Ritz- und Brechgräben 27" von einander getrennt. An den waagerechten Ritz- und Brechgräben 27" bzw. an den Ritz- und Brechgräben 27", welche die Stirnseiten der ersten Schaltungsträger 20" bilden, sind metallisch gefüllte Durchkontaktierungen 22", 24", so genannte Vias, angeordnet. Diese Vias 22", 24" werden durch nicht dargestellte Leiterbahnen elektrisch mit der elektronischen Schaltung bzw. den Bauelementen 25 verbunden. Sie werden beim Vereinzeln des Großsubstrats 5 in die einzelnen ersten Schaltungsträger 20" durch Ritzen und Brechen geteilt. Dabei werden die Vias 22", 24" durchtrennt und der zugehörige Metallkern wird freigelegt, so dass die metallischen Kantenkontakte 22", 24" nach außen hergestellt werden. Da die Vias beispielsweise mit Silber (Ag) gefüllt sind, werden die Kantenkontakte 22", 24" nach dem Vereinzeln mittels einer Leitpaste, eines Leitklebers oder einer Lotschicht 28" geschützt.

Ausführungsformen der Erfindung ermöglichen eine kostensparende Kontaktierung eines keramischen Schaltungsträger im Zuge des Fügens der Komponenten des Steuergeräts, so dass kurze Taktzeit umgesetzt und Investitionen für die Drahtkontaktierungsmittel eingespart werden können. Zudem stellen Ausführungsformen der Erfindung in vorteilhafter Weise eine Baukastenfähigkeit des Systems bezüglich unterschiedlicher Schaltungsträgergrößen, thermischer Anforderungen und unterschiedlicher Kundenstecker zur Verfügung. Ausführungsformen der Erfindung beruhen auf einer Kontaktiertechnik, bei welcher der Schaltungsträger bzw. das Keramiksubstrat in Führungsnuten eines Kunststoffgehäuses eingeschoben und im mechanischen Anschlag über in den Gehäusekunststoff eingespritzte Federkontakte zum Kundenstecker kontaktiert wird. Die Führungsnuten verjüngen sich im Bereich vor den Federkontakten am mechanischen Anschlag in einer Weise, dass die laterale Lage des keramischen Schaltungsträgers mit ausreichend kleiner Toleranz festgelegt ist, um die Federkontakte zu treffen. Nach dem Einschieben und Kontaktieren des Schaltungsträgers in das Gehäuse wird der Deckelteil des Gehäuses in gleicher Weise in die Führungsnut eingeschoben und mit dem Gehäuse, je nach Anforderung, dicht verklebt oder einfach verrastet. Im mechanischen Anschlag kontaktieren die in den Deckelteil eingespritzten Federkontakte, die über Stanzgitter zu nicht auf dem Keramiksubstrat platzierbaren Sonderbauelementen verbunden sind, ebenfalls zu Kontakten des Schaltungsträgers bzw. des Keramiksubstrates. Für Steuergeräte, deren Keramiksubstrat eine erhöhte Verlustleistung generiert, ist es möglich, den Schaltungsträger bzw. das Substrat auf einen Kühlkörper aufzukleben, der ebenfalls mit einer in die Gehäusenut einführbaren Feder versehenen ist.

## Patentansprüche

1. Steuergerät für ein Kraftfahrzeug mit einem Gehäuse (10, 10', 10") und mindestens einem Schaltungsträger (20, 20', 20"), welcher in einem Innenraum des Gehäuses (10, 10', 10") angeordnet ist und mindestens ein erstes Kontaktelement (22, 22") aufweist, welches an mindestens einer Gehäusewand (11, 11', 11") eine elektrische Verbindung mit mindestens einem zweiten Kontaktelement (17, 17") einer Steckeraufnahme (50, 50") herstellt, wobei das zweite Kontaktelement (17, 17") durch die mindestens eine Gehäusewand (11, 11', 11") geführt ist und innenseitig als Kontaktfeder ausgebildet ist, welche an einem zugeordneten ersten Kontaktelement (22, 22") durch Federkraft anliegt, wobei die mindestens eine Gehäusewand (11, 11', 11") Aufnahmemittel (11.1, 11.1', 11.1 ") für einen ersten Schaltungsträger (20, 20', 20") aufweist, wobei der erste Schaltungsträger (20, 20', 20") durch im Gehäuse (10, 10', 10") ausgebildete Führungsmittel (13.1, 14.1) geführt ist, wobei die Führungsmittel (13.1, 14.1) und/oder die Aufnahmemittel (11.1, 11.1', 11.1") einen mechanischen Anschlag (19, 19', 19") für den ersten Schaltungsträger (20, 20', 20") ausbilden, welcher so ausgeführt ist, dass die Lage des ersten Schaltungsträgers (20, 20', 20") im mechanischen Anschlag (19, 19', 19") mit ausreichend kleiner Toleranz so festlegt ist, dass die elektrische Verbindung zwischen dem mindestens einen ersten Kontaktelement (22, 22") des ersten Schaltungsträgers (20, 20', 20") und dem korrespondierenden als Kontaktfeder ausgeführten zweiten Kontaktelement (17, 17") der Steckeraufnahme (50, 50") hergestellt ist, **dadurch gekennzeichnet, dass** der erste Schaltungsträger (20, 20', 20") geführt durch die im Gehäuse (10, 10', 10") ausgebildeten Führungsmittel (13.1, 14.1) bis zu dem mechanischen Anschlag (19, 19', 19") eingeschoben ist, und
dass die Führungsmittel (13.1, 14.1) als Führungsnuten ausgeführt sind, welche jeweils in einer Gehäusewand (13, 14) so eingebracht sind, dass im Bereich vor dem als Kontaktfeder ausgeführten mindestens einen zweiten Kontaktelement (17, 17") eine Verjüngung entsteht.

2. Steuergerät nach Anspruch 1, **dadurch gekennzeichnet, dass** ein zweiter Schaltungsträger (30, 30") hinter dem ersten Schaltungsträger (20, 20', 20") in den Führungsmitteln (13.1, 14.1) geführt ist, wobei am zweiten Schaltungsträger (30, 30") mindestens ein als Kontaktfeder ausgeführtes drittes Kontaktelement (37, 37") angeordnet ist, welches zu mindestens einem korrespondierenden vierten Kontaktelement (24, 24") des ersten Schaltungsträgers (20, 20', 20") eine elektrische Verbindung herstellt.

3. Steuergerät nach Anspruch 1 oder 2, **dadurch gekennzeichnet, dass** das mindestens eine erste Kontaktelement (22, 22") und/oder das mindestens eine vierte Kontaktelement (24, 24") als Kontaktflächen ausgebildet sind, welche auf der Oberfläche des mindestens einen Schaltungsträgers (20, 20') und/oder am Außenrand des mindestens einen Schaltungsträgers (20") angeordnet sind.

4. Steuergerät nach Anspruch 3, **dadurch gekennzeichnet, dass** die am Außenrand angeordneten als Kontaktflächen ausgeführten ersten und/oder vierten Kontaktelemente (22", 24") durch metallisch gefüllte Durchkontaktierungen gebildet sind, welche so auf einem Großsubstrat (5) angeordnet sind, dass sie beim Ausschneiden des ersten Schaltungsträgers (20") aus dem Großsubstrat (5) teilbar sind.

5. Steuergerät nach einem der Ansprüche 1 bis 4, **dadurch gekennzeichnet, dass** das als Kontaktfeder ausgeführte mindestens eine zweite Kontaktelement (17, 17") zumindest teilweise in eine Stirnwand (11) des Gehäuses (10) eingespritzt ist.

6. Steuergerät nach einem der Ansprüche 1 bis 5, **dadurch gekennzeichnet, dass** ein Kühlkörper (26) auf dem ersten Schaltungsträger (20') angeordnet ist oder der erste Schaltungsträger (20') auf einem Kühlkörper (26) angeordnet ist, welcher in im Gehäuse ausgebildeten weiteren Führungsmitteln (13.2) geführt ist.

7. Verfahren zur Montage eines Steuergeräts für ein Kraftfahrzeug, das ein Gehäuse (10, 10', 10") und mindestens einen Schaltungsträger (20, 20', 20") aufweist, welcher in einem Innenraum des Gehäuses (10, 10', 10") angeordnet wird und mindestens ein erstes Kontaktelement (22, 22") aufweist, welches an mindestens einer Gehäusewand (11, 11', 11") eine elektrische Verbindung mit mindestens einem zweiten Kontaktelement (17, 17") einer Steckeraufnahme (50, 50") herstellt, wobei das zweite Kontaktelement (17, 17") durch die mindestens eine Gehäusewand (11, 11', 11") geführt wird und innenseitig als Kontaktfeder ausgebildet wird, welche an einem zugeordneten ersten Kontaktelement (22, 22") durch Federkraft anliegt, **dadurch gekennzeichnet, dass** ein erster Schaltungsträger (20, 20', 20") geführt durch im Gehäuse (10, 10', 10") ausgebildete Führungsmittel (13.1, 14.1) bis zu einem mechanischen Anschlag (19, 19', 19") in einen ersten Gehäuseteil (10.1) eingeschoben wird, wobei der mechanische Anschlag (19, 19', 19") für den ersten Schaltungsträger (20, 20', 20") durch in die mindestens eine Gehäusewand (11, 11', 11") eingebrachte Aufnahmemittel (11.1, 11.1', 11.1") und/oder die Führungsmittel (13.1, 14.1) ausgebildet wird, wobei die Lage des ersten Schaltungsträgers (20, 20', 20") im mechanischen Anschlag (19, 19', 19") mit ausreichend kleiner Toleranz so festlegt wird, dass die elektrische Verbindung zwischen dem mindestens einen ersten Kontaktelement (22, 22") und dem korrespondierenden als Kontaktfeder ausgeführten zweiten Kontaktelement (17, 17") hergestellt wird, und wobei die Führungsmittel (13.1, 14.1) als Führungsnuten ausgeführt werden, welche jeweils in einer Gehäusewand (13, 14) so eingebracht werden, dass im Bereich vor dem als Kontaktfeder ausgeführten mindestens einen zweiten Kontaktelement (17, 17") eine Verjüngung entsteht.

8. Verfahren nach Anspruch 7, **dadurch gekennzeichnet, dass** ein zweiter Schaltungsträger (30, 30") geführt in den Führungsmitteln (13.1, 14.1) hinter dem ersten Schaltungsträger (20, 20', 20") bis zum Anliegen am ersten Schaltungsträger (20, 20', 20") eingeschoben wird, wobei mindestens ein als Kontaktfeder ausgeführtes am zweiten Schaltungsträger (30, 30") angeordnetes drittes Kontaktelement (37, 37") mit mindestens einem korrespondierenden vierten Kontaktelement (24, 24") des ersten Schaltungsträgers (20, 20', 20") eine elektrische Verbindung herstellt.

9. Verfahren nach Anspruch 7 oder 8, **dadurch gekennzeichnet, dass** mit dem Einschieben des zweiten Schaltungsträgers (30, 30") ein zweites Gehäuseteil (10.2) mit dem ersten Gehäuseteil (10.1) zusammengefügt wird, wobei die beiden Gehäuseteile an mindestens einer Verbindungsstelle (40) mit einander verbunden werden.

## Claims

1. Control device for a motor vehicle, with a housing (10, 10', 10") and at least one circuit carrier (20, 20', 20"), which is arranged in an interior space of the housing (10, 10', 10") and has at least one first contact element (22, 22") which, on at least one housing wall (11, 11', 11"), produces an electric connection to at least one second contact element (17, 17") of a plug receptacle (50, 50"), wherein the second contact element (17, 17") is guided through the at least one housing wall (11, 11', 11") and, on the inside, is designed as a contact spring which bears against an associated first contact element (22, 22") by means of spring force, wherein the at least one housing wall (11, 11', 11") has receiving means (11.1, 11.1', 11.1") for a first circuit carrier (20, 20', 20"), the first circuit carrier (20, 20', 20") being guided by guide means (13.1, 14.1) formed in the housing (10, 10', 10"), the guide means (13.1, 14.1) and/or the receiving means (11.1, 11.1', 11.1") forming a mechanical stop (19, 19', 19") for the first circuit carrier (20, 20', 20"), said stop being designed in such a manner that the position of the first circuit carrier (20, 20', 20") in the mechanical stop (19, 19', 19") is fixed with a sufficiently small tolerance such that the electric connection is produced between the at least one first contact element (22, 22") of the first circuit carrier (20, 20', 20") and the corresponding second contact element (17, 17") of the plug receptacle (50, 50"), which second contact element is designed as a contact spring,
**characterized in that** the first circuit carrier (20, 20', 20''), guided by the guide means (13.1, 14.1) formed in the housing (10, 10', 10''), is pushed in as far as the mechanical stop (19, 19', 19"), and **in that** the guide means (13.1, 14.1) are designed as guide grooves which are each provided in a housing wall (13, 14) in such a manner that a tapered portion arises in the region upstream of the at least one second contact element (17, 17"), which is designed as a contact spring.

2. Control device according to Claim 1, **characterized in that** a second circuit carrier (30, 30") is guided in the guide means (13.1, 14.1) downstream of the first circuit carrier (20, 20', 20"), at least one third contact element (37, 37"), which is designed as a contact spring, being arranged on the second circuit carrier (30, 30") and producing an electric connection to at least one corresponding fourth contact element (24, 24") of the first circuit carrier (20, 20', 20").

3. Control device according to Claim 1 or 2, **characterized in that** the at least one first contact element (22, 22") and/or the at least one fourth contact element (24, 24") are/is designed as contact surfaces which are arranged on the surface of the at least one circuit carrier (20, 20') and/or on the outer edge of the at least one circuit carrier (20").

4. Control device according to Claim 3, **characterized in that** the first and/or fourth contact elements (22", 24"), which are arranged on the outer edge and are designed as contact surfaces, are formed by metallically filled vias which are arranged on a large substrate (5) in such a manner that they can be divided when the first circuit carrier (20") is cut out of the large substrate (5).

5. Control device according to one of Claims 1 to 4, **characterized in that** the at least one second contact element (17, 17"), which is designed as a contact spring, is at least partially injected into an end wall (11) of the housing (10).

6. Control device according to one of Claims 1 to 5, **characterized in that** a heat sink (26) is arranged on the first circuit carrier (20'), or the first circuit carrier (20') is arranged on a heat sink (26) which is guided in further guide means (13.2) formed in the housing.

7. Method for mounting a control device for a motor vehicle, which has a housing (10, 10', 10") and at least one circuit carrier (20, 20', 20"), which is arranged in an interior space of the housing (10, 10', 10") and has at least one first contact element (22, 22") which, on at least one housing wall (11, 11', 11"), produces an electric connection to at least one second contact element (17, 17") of a plug receptacle (50, 50"), wherein the second contact element (17, 17") is guided through the at least one housing wall (11, 11', 11") and, on the inside, is designed as a contact spring which bears against an associated first contact element (22, 22") by means of spring force, **characterized in that** a first circuit carrier (20, 20', 20"), guided by guide means (13.1, 14.1) formed in the housing (10, 10', 10"), is pushed into a first housing part (10.1) as far as a mechanical stop (19, 19', 19"), the mechanical stop (19, 19', 19") for the first circuit carrier (20, 20', 20") being formed by receiving means (11.1, 11.1', 11.1") provided in the at least one housing wall (11, 11', 11") and/or by the guide means (13.1, 14.1), the position of the first circuit carrier (20, 20', 20") in the mechanical stop (19, 19', 19") being fixed with a sufficiently small tolerance such that the electric connection is produced between the at least one first contact element (22, 22") and the corresponding second contact element (17, 17"), which is designed as a contact spring, and wherein the guide means (13.1, 14.1) are designed as guide grooves which are each provided in a housing wall (13, 14) in such a manner that a tapered portion arises in the region upstream of the at least one second contact element (17, 17"), which is designed as a contact spring, and wherein the guide means (13.1, 14.1) are designed as guide grooves which are each provided in a housing wall (13, 14) in such a manner that a tapered portion arises in the region upstream of the at least one second contact element (17, 17"), which is designed as a contact spring.

8. Method according to Claim 7, **characterized in that** a second circuit carrier (30, 30"), guided in the guide means (13.1, 14.1) downstream of the first circuit carrier (20, 20', 20"), is pushed in until it bears against the first circuit carrier (20, 20', 20"), and at least one third contact element (37, 37"), which is designed as a contact spring and is arranged on the second circuit carrier (30, 30"), produces an electric connection to at least one corresponding fourth contact element (24, 24") of the first circuit carrier (20, 20', 20").

9. Method according to Claim 7 or 8, **characterized in that**, with the pushing-in of the second circuit carrier (30, 30"), a second housing part (10.2) is joined together with the first housing part (10.1), the two housing parts being connected to each other at at least one connecting point (40).

## Revendications

1. Appareil de commande pour un véhicule automobile comprenant un boîtier (10, 10', 10'') et au moins un support de circuit (20, 20', 20''), lequel est disposé dans un espace interne du boîtier (10, 10', 10") et présente au moins un premier élément de contact (22, 22'') qui établit au niveau d'au moins une paroi de boîtier (11, 11', 11'') une connexion électrique avec au moins un deuxième élément de contact (17, 17'') d'une prise (50, 50''), le deuxième élément de contact (17, 17'') étant guidé à travers l'au moins une paroi de boîtier (11, 11', 11'') et étant réalisé du côté interne en tant que ressort de contact qui s'applique avec une force de ressort contre un premier élément de contact associé (22, 22''), l'au moins une paroi de boîtier (11, 11', 11'') présentant des moyens de réception (11.1, 11.1', 11.1") pour un premier support de circuit (20, 20', 20"), le premier support de circuit (20, 20', 20") étant guidé par des moyens de guidage (13.1, 14.1) réalisés dans le boîtier (10, 10', 10''), les moyens de guidage (13.1, 14.1) et/ou les moyens de réception (11.1, 11.1', 11.1'') constituant une butée mécanique (19, 19', 19'') pour le premier support de circuit (20, 20', 20''), laquelle butée est réalisée de telle sorte que la position du premier support de circuit (20, 20', 20'') dans la butée mécanique (19, 19', 19'') soit fixée avec une tolérance suffisamment petite pour que la connexion électrique soit établie entre l'au moins un premier élément de contact (22, 22'') du premier support de circuit (20, 20', 20'') et le deuxième élément de contact (17, 17'') de la prise (50, 50") correspondant réalisé en tant que ressort de contact, **caractérisé en ce que** le premier support de circuit (20, 20', 20''), guidé à travers les moyens de guidage (13.1, 14.1) réalisés dans le boîtier (10, 10', 10''), est enfoncé jusqu'à la butée mécanique (19, 19', 19'') et **en ce que** les moyens de guidage (13.1, 14.1) sont réalisés en tant que rainures de guidage qui sont pratiquées respectivement dans une paroi de boîtier (13, 14) de telle sorte que dans la région avant l'au moins un deuxième élément de contact (17, 17") réalisé en tant que ressort de contact soit formé un rétrécissement.

2. Appareil de commande selon la revendication 1, **caractérisé en ce qu'**un deuxième support de circuit (30, 30") est guidé derrière le premier support de circuit (20, 20', 20'') dans les moyens de guidage (13.1, 14.1), au moins un troisième élément de contact (37, 37'') réalisé en tant que ressort de contact étant disposé sur le deuxième support de circuit (30, 30''), lequel établit une connexion électrique avec au moins un quatrième élément de contact correspondant (24, 24'') du premier support de circuit (20, 20', 20'').

3. Appareil de commande selon la revendication 1 ou 2, **caractérisé en ce que** l'au moins un premier élément de contact (22, 22'') et/ou l'au moins un quatrième élément de contact (24, 24'') sont réalisés en tant que surfaces de contact qui sont disposées sur la surface de l'au moins un support de circuit (20, 20') et/ou sur le bord extérieur de l'au moins un support de circuit (20'').

4. Appareil de commande selon la revendication 3, **caractérisé en ce que** les premier et/ou quatrième éléments de contact (22", 24") réalisés en tant que surfaces de contact disposés sur le bord extérieur sont formés par des contacts traversants qui sont disposés sur un substrat grossier (5) de telle sorte que lors de la découpe du premier support de circuit (20''), ils puissent être séparés du substrat grossier (5).

5. Appareil de commande selon l'une quelconque des revendications 1 à 4, **caractérisé en ce que** l'au moins un deuxième élément de contact (17, 17'') réalisé en tant que ressort de contact est au moins en partie injecté dans une paroi frontale (11) du boîtier (10).

6. Appareil de commande selon l'une quelconque des revendications 1 à 5, **caractérisé en ce qu'**un corps de refroidissement (26) est disposé sur le premier support de circuit (20') ou le premier support de circuit (20') est disposé sur un corps de refroidissement (26) qui est guidé dans d'autres moyens de guidage (13.2) réalisés dans le boîtier.

7. Procédé de montage d'un appareil de commande pour un véhicule automobile qui présente un boîtier (10, 10', 10'') et au moins un support de circuit (20, 20', 20''), lequel est disposé dans un espace interne du boîtier (10, 10', 10'') et présente au moins un premier élément de contact (22, 22'') qui établit au niveau d'au moins une paroi de boîtier (11, 11', 11'') une connexion électrique avec au moins un deuxième élément de contact (17, 17'') d'une prise (50, 50''), le deuxième élément de contact (17, 17'') étant guidé à travers l'au moins une paroi de boîtier (11, 11', 11'') et étant réalisé du côté interne en tant que ressort de contact qui s'applique avec une force de ressort contre un premier élément de contact associé (22, 22''), **caractérisé en ce qu'**un premier support de circuit (20, 20', 20''), guidé par des moyens de guidage (13.1, 14.1) réalisés dans le boîtier (10, 10', 10'') est enfoncé jusqu'à une butée mécanique (19, 19', 19'') dans une première partie de boîtier (10.1), la butée mécanique (19, 19', 19") pour le premier support de circuit (20, 20', 20'') étant réalisée par des moyens de réception (11.1, 11.1', 11.1'') pratiqués dans l'au moins une paroi de boîtier (11, 11', 11") et/ou par les moyens de guidage (13.1, 14.1), la position du premier support de circuit (20, 20', 20") dans la butée mécanique (19, 19', 19") étant fixée avec une tolérance suffisamment petite pour que la connexion électrique soit établie entre l'au moins un premier élément de contact (22, 22'') et le deuxième élément de contact (17, 17'') correspondant réalisé en tant que ressort de contact, et les moyens de guidage (13.1, 14.1) étant réalisés sous forme de rainures de guidage qui sont pratiquées respectivement dans une paroi de boîtier (13, 14) de telle sorte que dans la région avant l'au moins un deuxième élément de contact (17, 17'') réalisé en tant que ressort de contact soit formé un rétrécissement.

8. Procédé selon la revendication 7, **caractérisé en ce qu'**un deuxième support de circuit (30, 30''), guidé dans les moyens de guidage (13.1, 14.1) derrière le premier support de circuit (20, 20', 20''), est enfoncé jusqu'à venir en appui contre le premier support de circuit (20, 20', 20''), au moins un troisième élément de contact (37, 37'') réalisé en tant que ressort de contact et disposé sur le deuxième support de circuit (30, 30'') établissant une connexion électrique avec au moins un quatrième élément de contact correspondant (24, 24'') du premier support de circuit (20, 20', 20'').

9. Procédé selon la revendication 7 ou 8, **caractérisé en ce qu'**avec l'insertion du deuxième support de circuit (30, 30'') une deuxième partie de boîtier (10.2) est assemblée à la première partie de boîtier (10.1), les deux parties de boîtier étant connectées l'une à l'autre au niveau d'au moins une zone de connexion (40).
